# EUROPEAN PATENT APPLICATION

(11) **EP 1 873 812 A1**
(43) Date of publication of application: **02.01.2008**
(21) Application number: 06291070.8
(22) Date of filing: 26.06.2006
(51) Int. Cl.: H01L 21/00, H01L 21/687, H01L 23/544

(54) **Wafer frame**

(71) Applicant: Axalto SA, 92190 Meudon (FR)
(72) Inventor: Zaleski, Olivier, Axalto S.A., 92190 Meudon (FR)
(74) Representative: Cour, Pierre

(57) **Abstract**

The invention is a wafer frame 1 comprising a rigid flat frame 2, a thin film 3, a wafer 4 and a memory device 6. The memory device 6 is placed in the frame 2 for carrying wafer-associated data together with the wafer 4. The drawback due to the downloading of a file associated to the wafer 4 over the Internet and human errors are prevented.

## Description

### BACKGROUND OF THE INVENTION

### 1. Field of the Invention

The invention relates to a wafer frame. More particularly, the invention relates to the frame used for carrying a wafer and sawing it.

### 2. Related Art

Integrated circuits (IC) are manufactured on a wafer made of a semiconductor material. Typically, a wafer comprises few hundred to several thousands of IC. The manufacturing process consist in several patterning of different materials for doping of N-type or P-type the wafer, then several layers of insulating materials and conductive material are deposited, patterned and etched. When the ICs are completed, the wafer may be back grind to be thinner. Then the wafer is divided into individual dices and each dice is embedded.

The manufacturing steps are commonly performed in a single manufacture but sometimes the sawing of the wafers and the embedding (or packaging in case), including the die-bonding, can be made in another manufacture. As an example, for making smart cards, ICs must be embedded in specific cases know as modules. Commonly, IC manufacturers do not perform such specific embedding. So, the ICs are bought in wafers and the module manufacturer performs the sawing step and the embedding into the modules.

When the lCs are delivered in wafer form, they are placed on a wafer film maintained into a rigid frame that can be easily handled. As well known in the art, there are always a number of bad circuits on a wafer. For preventing the die-bonding and the embedding of bad chips, the IC manufacturer has previously marked the bad IC of the wafer. For small wafer, up to 8 inches, an ink dot is deposited over each bad chip of a wafer. For large wafer, for example 12-inches wafers, a computer wafer-mapping file is made, this file is descriptive of the mapping of the IC on the wafer and indicates the good/bad status of each IC.

Today, manufacturer delivers the wafer frames with a label indicating the serial number of the wafer together with a corresponding bar code. The wafer-mapping file is available on an FTP server of the manufacturer over Internet, or through another communication channel. For selecting the ICs before embedding, it is necessary to download the file. Even if communication is efficient, sometimes there is some unavailability of networks that make impossible the downloading of the file. Such a downloading problem may stop the embedding process.

Commonly, an operator downloads the file from the server on a floppy disc before loading said file into a die-bonder or another manufacturing machine. This corresponds to a manufacturing cost and may introduce human error in the manufacturing process. In addition, for security reasons, it is common not to connect manufacturing machine to Internet.

### SUMMARY OF THE INVENTION

The invention provides a solution to the previous cited problems. A memory device is placed in the frame for carrying the wafer-mapping file together with the wafer. With the invention, the drawback due to the downloading of the file over the Internet and human error are prevented.

According a first aspect, the invention is a wafer frame comprising a rigid flat frame, a thin film, a wafer and a memory device. The rigid flat frame has at least two opposite faces and a cavity emerging on the two opposite faces. The thin film is attached on one face of the rigid flat frame and recovers the cavity. The wafer comprises a plurality of circuits arranged according a structure type in row and columns on an active face of said wafer. Said wafer is placed into the cavity far from the rigid flat frame and attached to the thin film on a face opposite to the active face. The memory device is attached to the rigid flat frame.

Preferentially, the rigid flat frame comprises a second cavity emerging at least on one face by an access hole and wherein the memory device is fixed into the second cavity and can be accessed through the hole. The memory device may be a memory card or a smart card having connecting areas facing to the hole. The memory device may comprise a wireless interface linked to an antenna, said interface being capable of communicating with a wireless reader. The memory device may comprise a power supply circuit linked to the antenna, said power supply circuit recovering power supply from an electromagnetic field coming from the reader. The memory device may comprise a non-volatile electrically erasable memory circuit. The memory device may contain a file associated to the wafer. The file is a wafer-mapping file.

According a second aspect, the invention is a manufacturing machine comprising holding means, operation means, control means and a memory reader interface. The holding means maintain in a fixed manner a frame carrying a wafer. The operation means perform a manufacturing step on the wafer. The control means controls the operation means. The memory reader interface communicates with a memory device located in the frame. Information exchanged between the memory device and the reader are used by the control means for controlling the operation on the wafer.

### BRIEF DESCRIPTION OF THE DRAWINGS

The invention will be better understood and further advantages will be disclosed in the following description of a non-limiting example of realization of the invention wherein reference is made to the following drawings:
Fig. 1 is an upper view of a wafer frame according to the invention,
Fig. 2 is a partial cross section of the frame of Fig. 1,
Fig. 3 is a partial side view of the frame of Fig. 1, and
Fig. 4 is an example of manufacturing machine coopering with a frame according to the invention.

### DETAILED DESCRIPTION OF THE INVENTION

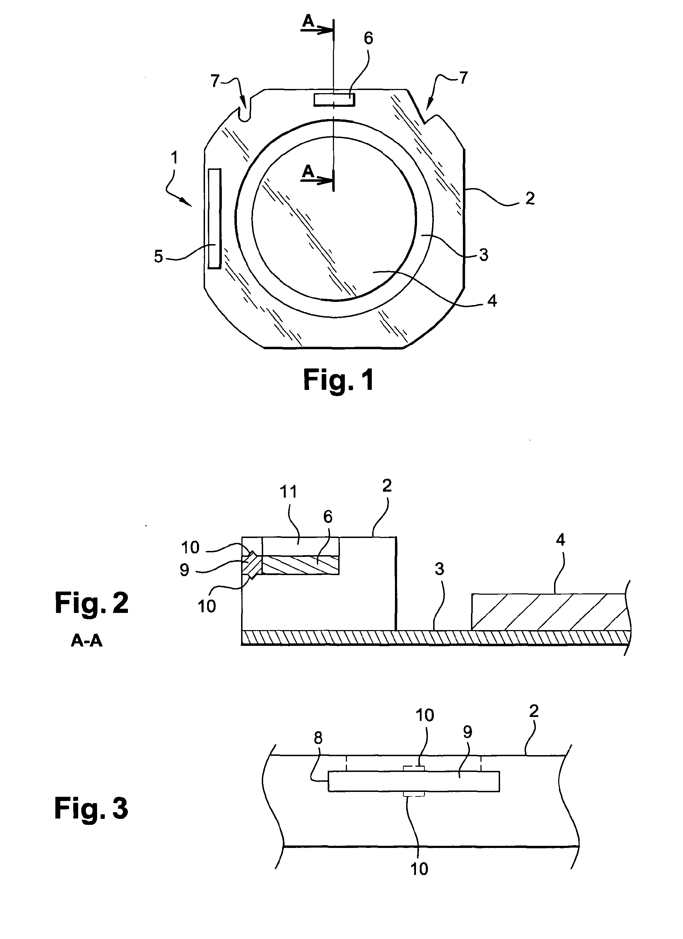

Figs. 1 to 3 shows a same wafer frame according different views. For a better understanding of some details, the scale is not respected on the drawings and a same reference is used for defining a same thing.

The wafer frame 1 comprises a rigid flat frame 2, a thin film 3, a wafer 4, a label 5 and a memory device 6. The rigid flat frame 2 may be made of plastic or metal, and it is commonly resistant to warping, bending corrosion and heat. The rigid flat frame 2 has two opposite faces and defines a cavity emerging on the two opposite faces for receiving the wafer 4. The cavity is a circular cavity having a diameter greater than the wafer diameter added to a clearance margin. The thickness of the frame is commonly around 3 mm. The rigid flat frame 2 further comprises two notches 7 used for positioning and mistake proofing when the wafer frame 1 is mounted on a manufacturing machine.

The thin film 3 (also known as dicing tape) is for example a PVC sheet with a synthetic adhesive on one side to hold both the rigid flat frame 2 and the wafer 4. Typically, the thin film 3 measures between 50 to 100 µm and it should be flexible yet tough and strong, and with low impurity levels as well. The thin film 3 is used for carrying the wafer 4 during transport, sawing and separating dices up to the placement of each dice into an individual package.

The wafer 4 is a disc of semiconductor material having a thickness of few hundreds of micrometer, for example 200 µm after thinning. The diameter can be of 12 inches (30 cm). The wafer 4 comprises a plurality of circuits arranged according a structure type in rows and columns on an active face. The wafer 4 is attached to the thin film 3 on the face opposite to the active face.

The label 5 is attached to the rigid flat frame 2 on one face. The label 5 is used for identifying the wafer 4 carried by the wafer frame 1. The identification may comprise an identification number of the circuits of the wafer but also the serial number of the wafer and a production lot number. The identification is preferentially made with readable character and a corresponding bar code.

The memory device 6 is added according to the invention. This memory device may be choose in the large memory device types known in the art: smart card, multimedia card (MMC), SD card or any flash memory device. Preferentially, a smart card is used for cost reasons. The memory device stores one or more files associated to the wafer 4. The main file stored is the wafer-mapping file that comprises all information needed for cutting the wafer and using the dices. As an example, the wafer-mapping file may comprises one or more of the following information: a size of a wafer, a position of the wafer into the frame, a production lot number, a wafer identification or serial number, a structure of the wafer, a number of columns of circuits on the wafer, a number of rows of circuits on the wafer, a map structure type, an array of bits, at least one bit being associated to each circuit of the wafer, the bit value indicating if the associated circuit is a good circuit or a bad circuit. Such a file takes few tens of kilobytes and is easily storable into a memory card or smart card.

The rigid flat frame 2 comprises a cavity for receiving the memory device 6. According to a preferred embodiment, this cavity is a slot 8 having a lateral opening for introducing a smart card of plug-type. An elastic stopper 9 is used for maintaining the plug into the slot. The stopper 9 is for example made of a rubber or rubber-like material and may comprise fins coopering - with grooves 10 placed into the slot 8.

The slot 8 has an access hole 11 like a window, for accessing contact areas of the smart card (or other kind of memory card). In that way, the contact areas of the card must face the access hole. Then a reader head can contact the smart card.

The access hole may become unnecessary if the smart card is a wireless card that comprises a wireless interface capable of communicating with a wireless reader. The wireless card may contain an antenna used both for communication and for power supply. The power supply is recovered from an electromagnetic field provided by the reader. But wireless can be used only with a non-conductive rigid flat frame 2.

Other kind of cavity and fixing means can be used for attaching the memory device 6 to the rigid flat frame 2.

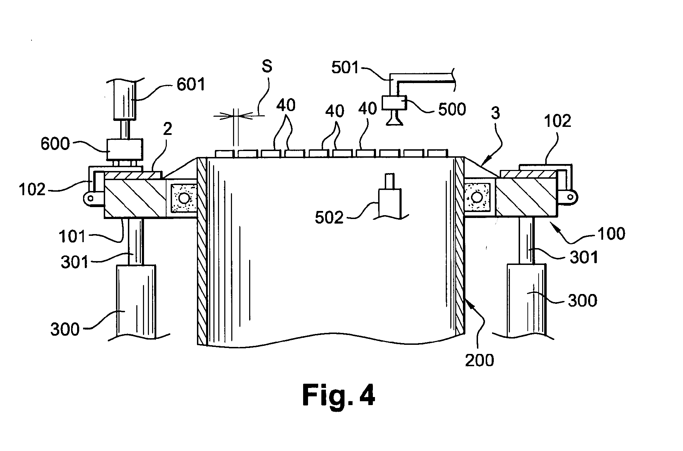

Fig. 4 shows an example of manufacturing machine adapted for the invention. The manufacturing machine is for example a die-bonder. Said die-bonder comprises frame holding means 100 comprising a placing member 101 having a flat annular surface on which is placed the rigid flat frame 2. Clamps 102 immobilize the rigid flat frame 2. The placing member 101 comprises a hole for enabling the passage of a tension exerting drums 200. The placing member 101 and the tension exerting drums 200 move one from the other by means of air cylinders 300 linked to the drums 200 cooperating with their piston rod 301 linked to placing member 101. The action of the tension exerting drums 200 expands the thin film 3 and increases the space S between the dices 40 resulting from the sawing of the wafer 4. After expansion of the thin film 3, the dices 40 can be easily pick-up by a depression holding head 500 placed at an extremity of a manipulation arm 501 that cooperates with a pusher 502 placed into the drum 200 for locally pushing one dice.

The manipulation arm 501, the holding head 500 and the pusher 502 are used for taking a dice 40 corresponding to a good circuit and putting it in a bonding area, as well known in the art. The manipulation arm 501, the holding head 500 and the pusher 502 are controlled by control means (not shown on the figure). For determining the good and bad dices (or circuits), the control means uses a reader head 600 mounted for example on an air cylinder 601. The reader head 600 is in electric contact with contact areas of the memory device of the wafer frame 1. So the wafer-mapping file can be transferred from the memory device to the control means and used by said means for controlling the arm during the process step.

The use of the memory device fastens the manufacturing because the operator has only to place the wafer frame on the manufacturing machine without operation to do for transferring the file to the machine. In addition, it is impossible to make an error because the memory device contain is associated with the wafer carried by the wafer frame.

Many other manufacturing machines that require information related to the wafer for performing their manufacturing step can be easily adapted by addition of a reader head.

## Claims

1. A wafer frame (1) comprising:
- a rigid flat frame (2) having at least two opposite faces and a cavity emerging on the two opposite faces,
- a thin film (3) attached on one face of the rigid flat frame (2) and recovering the cavity, and
- and a wafer (4) comprising a plurality of circuits (40) arranged according a structure type in row and columns on an active face of said wafer (4), said wafer being placed into the cavity far from the rigid flat frame (2) and attached to the thin film (3) on a face opposite to the active face,
**Characterized in that** the wafer frame further comprises a memory device (6) attached to the rigid flat frame (2).

2. The wafer frame of claim 1, wherein the rigid flat frame (2) comprises a second cavity (8) emerging at least on one face by a access hole (11) and wherein the memory device (6) is fixed into the second cavity and can be accessed through the hole.

3. The wafer frame of claim 2, wherein the memory device (6) is a memory card or a smart card having connecting areas facing to the hole.

4. The wafer frame of claim 1, wherein the memory device (6) comprises a wireless interface linked to an antenna, said interface being capable of communicating with a wireless reader.

5. The wafer frame of claim 4, wherein the memory device (6) comprises a power supply circuit linked to the antenna, said power supply circuit recovering power supply from an electromagnetic field coming from the reader.

6. The wafer frame of claim 1, wherein the memory device (6) comprises a non-volatile electrically erasable memory circuit.

7. The wafer frame of claim 1, wherein the memory device (6) contains a file associated to the wafer.

8. The wafer frame of claim 7, wherein the file is a wafer-mapping file.

9. The wafer frame of claim 7, wherein the file comprises one or more of the following information:
- a size of a wafer,
- a position of the wafer into the frame,
- a production lot number,
- a wafer identification or serial number,
- a structure of the wafer,
- a number of columns of circuits on the wafer,
- a number of rows of circuits on the wafer,
- a map structure type,
- an array of bits, at least one bit being associated to each circuit of the wafer, the bit value indicating if the associated circuit is a good circuit or a bad circuit.

10. A manufacturing machine comprising:
- holding means (100-102) for maintaining in a fixed manner a frame (2) carrying a wafer (4),
- operation means (500-502) for performing a manufacturing step on the wafer (4),
- control means that controls the operation means,
**characterized in that** said machine further comprises a memory reader interface (600) for communicating with a memory device (6) located in the frame (2) and wherein information exchanged between the memory device and the reader are used by the control means for controlling the operation on the wafer.
